(19) **Europäisches Patentamt / European Patent Office / Office européen des brevets**

(11) **EP 3 607 585 B1**

(12) **FASCICULE DE BREVET EUROPEEN**

(45) Date de publication et mention de la délivrance du brevet:
**01.10.2025 Bulletin 2025/40**

(21) Numéro de dépôt: **18716250.8**

(22) Date de dépôt: **06.04.2018**

(51) Classification Internationale des Brevets (IPC):
**G02B 3/00** *(2006.01)* **G02B 5/20** *(2006.01)*
**G01J 3/12** *(2006.01)* **G01J 3/28** *(2006.01)*
**G01J 3/36** *(2006.01)* **H10F 39/18** *(2025.01)*
**H10F 39/00** *(2025.01)*

(52) Classification Coopérative des Brevets (CPC):
**H10F 39/184; G01J 3/12; G01J 3/2803;
G01J 3/2823; G01J 3/36; H10F 39/1847;
H10F 39/8053; H10F 39/806;** G01J 2003/1213;
G01J 2003/2806; G01J 2003/2826; G02B 3/0006;
G02B 5/201

(86) Numéro de dépôt international:
**PCT/EP2018/058822**

(87) Numéro de publication internationale:
**WO 2018/185265 (11.10.2018 Gazette 2018/41)**

(54) **DISPOSITIF ET PROCEDE D'IMAGERIE MULTISPECTRALE DANS L'INFRAROUGE**

VORRICHTUNG UND VERFAHREN ZUR MULTISPEKTRALEN BILDGEBUNG IM INFRAROTBEREICH

DEVICE AND METHOD FOR MULTISPECTRAL IMAGING IN THE INFRARED

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.04.2017 FR 1753017**

(43) Date de publication de la demande:
**12.02.2020 Bulletin 2020/07**

(73) Titulaires:
* **Office National d'Etudes et de Recherches Aérospatiales**
  **91120 Palaiseau (FR)**
* **Centre National de la Recherche Scientifique CNRS**
  **75794 Paris Cedex 16 (FR)**

(72) Inventeurs:
* **BIERRET, Antoine**
  **78000 Versailles (FR)**
* **VINCENT, Grégory**
  **91300 Massy (FR)**
* **HAIDAR, Riad**
  **75012 Paris (FR)**
* **PARDO, Fabrice**
  **94400 Vitry-sur-Seine (FR)**
* **PELOUARD, Jean-Luc**
  **75020 Paris (FR)**

(74) Mandataire: **IPAZ**
**Bâtiment Platon**
**Parc Les Algorithmes**
**91190 Saint-Aubin (FR)**

(56) Documents cités:
EP-A1- 2 616 855      WO-A2-2009/106316
US-A1- 2004 108 564      US-A1- 2013 277 560
US-B1- 7 807 951

## Description

### Domaine technique

La présente invention concerne un dispositif et un procédé d'imagerie multispectrale dans l'infrarouge.

### Etat de l'art

Dans le visible ou le proche infrarouge, différents moyens sont connus pour la formation d'images en couleur au moyen de caméras numériques de type CCD ou CMOS. Il est possible par exemple d'utiliser des moyens de séparation spectrale pour former sur plusieurs détecteurs des images respectivement dans différentes bandes spectrales. Il est connu également de placer une roue à filtres devant la caméra et d'acquérir séquentiellement une série d'images dans différentes bandes spectrales. Dans chacun de ces cas, l'image en couleur est reconstruite à partir des différentes images acquises dans les différentes bandes spectrales. La technique la plus utilisée est cependant la structuration du plan focal pour former une mosaïque de filtres pixellisés, par exemple sous forme d'une structuration dite « structuration de Bayer » (décrite dans le brevet US 3971065) qui permet d'acquérir simultanément et avec un seul détecteur des images dans des différentes bandes spectrales afin de reproduire au plus près la vision de l'œil humain. Pour ce faire, des filtres rouge, vert et bleu sont positionnés au niveau de chacun des détecteurs élémentaires de la caméra (ou « pixels ») sous forme d'une mosaïque de 4 filtres pixellisés (un rouge, 2 verts, un bleu), ce motif étant reproduit sur toute la surface du détecteur. Un algorithme de « démosaïquage » permet ensuite de reconstruire l'image en couleur. Les filtres pixellisés sont généralement réalisés dans le proche infrarouge sous forme de structures multicouches formant des filtres interférentiels (voir par exemple M. Lequime et al., « 2 × 2-Array Pixelated Optical Interference Filters », Proc. SPIE Vol. 9627, 96270V-1 - 96270V-7, 2015) et la technologie est très bien maîtrisée. Dans le visible, on peut utiliser aussi des colorants.

Dans l'infrarouge, c'est-à-dire pour des longueurs d'onde comprises typiquement entre 3 $\mu$m et 20 $\mu$m, le besoin d'imagerie multispectrale existe également, non pas pour reproduire une image similaire à celle détectée par l'œil, mais pour accéder à des informations diverses comme par exemple l'identification d'une espèce chimique ou d'un objet grâce à sa signature spectrale, l'analyse en température d'un corps émissif, la détermination de l'émissivité spectrale d'un corps, etc.

L'utilisation de structures multicouches pour l'imagerie infrarouge multispectrale dans la bande 3 - 5 $\mu$m a été décrite mais elle présente un certain nombre de limitations (voir M. Oussalah et al. "Multispectral thin film coating on infrared detector", Proc. SPIE., Vol. 9627, 96271W-96271W-10, (2015)). En particulier, dès lors qu'ils font intervenir un grand nombre de couches ces composants, si les matériaux ne sont pas choisis avec beaucoup de précaution, peuvent présenter une fragilité dès qu'ils sont soumis à des variations de température. Par ailleurs, dans l'infrarouge, les épaisseurs des couches sont importantes (typiquement supérieures à 1 $\mu$m) et variables d'un filtre à l'autre. Cela entraîne non seulement des difficultés technologiques mais peut résulter à une détérioration des performances en terme de sélectivité spectrale du fait d'effets parasites de diffraction (effets de bords) résultant notamment des différences d'épaisseur de filtre à filtre.

D'autres techniques ont été développées pour l'imagerie multispectrale dans l'infrarouge, basées non plus sur un empilement de couches mais sur des structurations périodiques sub longueurs d'onde de couches métalliques, permettant notamment de travailler avec un nombre limité de couches.

Ainsi, Haïdar et al. ("Free-standing subwavelength metallic gratings for snapshot multispectral imaging", Appl. Phys. Lett. 96, 221104, (2010)) décrit une caméra infrarouge multispectrale basée sur l'utilisation de réseaux métalliques sub longueurs d'onde suspendus. Ces structures présentent des transmissions remarquables à des longueurs d'ondes qui dépendent de la période. En juxtaposant plusieurs filtres de périodes différentes, il est ainsi possible de réaliser une caméra à plusieurs voies optiques imageantes, chaque voie comprenant en outre un filtre spectral, ce qui permet de former pour chaque voie une image sur une surface donnée, typiquement une surface millimétrique, dans une bande spectrale donnée.

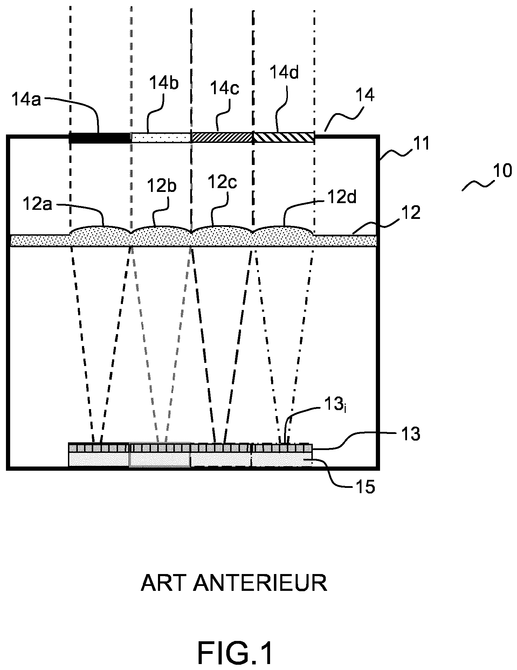

La FIG. 1 illustre ainsi une caméra infrarouge multivoies 10 selon l'art antérieur. La caméra comprend un ensemble de lentilles, ou microlentilles, agencées par exemple dans une enceinte 11. Ces lentilles, référencées 12a, 12b, 12c, 12d sur la FIG. 1, sont adaptées pour la formations d'images sur une matrice de détection 13 formée de détecteurs élémentaires (ou « pixels ») $13_i$. En amont de chacune des lentilles 12i, par exemple au niveau d'une fenêtre d'entrée de l'enceinte 11, se trouve une matrice de filtres 14 adaptée pour le filtrage en transmission dans des bandes spectrales centrées sur des longueurs d'onde de détection données. En choisissant pour chacun des filtres référencés 14a, 14b, 14c, 14d sur la FIG. 1 des bandes spectrales de transmission centrées sur des longueurs d'onde de détection différentes, on forme sur la matrice de détecteurs élémentaires 13, 4 images de « couleurs » différentes sur des surfaces de détection typiquement de dimensions millimétriques. Un circuit de lecture 15 est adapté pour le traitement des signaux détectés pour chacune des images et la transmission des signaux vers une unité de calcul (non représentée). On parle ainsi de caméra « multivoies ».

Dans Sakat et al. 2011 (« Guided mode resonance in subwavelength metallodielectric free-standing grating for bandpass filtering », Opt. Lett.36, 3054 (2011)) et Sakat et al. 2013 ("Metal-dielectric bi-atomic structure for angular-tolerant spectral filtering", Opt. Lett., 38, 425, (2013)) sont décrits des filtres à résonance de mode guidé (ou « GMR » selon l'abréviation de l'expression « Guided Mode Resonance ») métallo-diélectriques. Ces filtres reposent sur une résonance de mode guidé dans une couche mince en diélectrique, dont le couplage à l'espace libre est assuré par un réseau métallique, en particulier pour les ordres $\pm 1$ diffractés dans le diélectrique. Par rapport aux structures décrites dans Haïdar *et al.,* ces filtres peuvent présenter une meilleure tolérance angulaire (voir Sakat *et al.* 2013) ce qui permet, lorsqu'ils sont implantés dans une configuration de caméra multivoies telle qu'illustré sur la FIG. 1, de travailler avec de plus grands champs tout en gardant les performances spectrales des filtres.

Cependant, dans les filtres basés sur des structurations périodiques sub longueurs d'onde telles que décrits précédemment, seule la réponse des filtres GMR en ondes planes a été considérée, éventuellement en fonction de l'angle d'incidence de cette onde, pour une utilisation sur de grandes surfaces (typiquement des surfaces millimétriques), comme dans la caméra multivoies décrite sur la FIG. 1.

Pour la première fois, il est démontré dans la présente demande la faisabilité d'un dispositif d'imagerie multispectrale dans l'infrarouge avec des filtres GMR métallo-diélectriques opérant sur des surfaces de la dimension du pixel de détection, ouvrant la voie à de nouveaux imageurs compacts pour l'acquisition instantanée d'images infrarouges « en couleur ».

RESUME

Selon un premier aspect, la présente description concerne un dispositif selon la revendication 1.

Un filtre élémentaire à résonance de mode guidé métallo-diélectrique, optimisé pour la transmission passe bande dans une bande spectrale centrée sur une longueur d'onde de détection $\lambda_d$ donnée, comprend, au sens de la présente description, une couche en matériau diélectrique formant un guide d'onde monomode à ladite longueur d'onde de détection $\lambda_d$, et au moins un réseau diffractif métallique, structuré selon un motif donné répété avec une période donnée, inférieure à ladite longueur d'onde de détection. Au moins un réseau de diffraction est adapté pour le couplage d'une onde incidente à ladite longueur d'onde de détection $\lambda_d$ au mode du guide d'onde.

Selon un ou plusieurs exemples de réalisation, un motif de structuration du réseau diffractif comprend une ou plusieurs ouvertures, de dimensions prédéterminées, les ouvertures étant remplies d'un matériau diélectrique pouvant être l'air ambiant ou un autre matériau diélectrique comme par exemple le matériau diélectrique formant le guide d'onde ou celui formant un substrat. Les ouvertures peuvent présenter des formes de fentes monodimensionnelles de largeurs données, de fentes de largeurs données agencées selon deux directions perpendiculaires, des formes de croix, ou peuvent être des ouvertures circulaires, etc. En fonction de la géométrie de l'ouverture, le filtre élémentaire peut se montrer sélectif en polarisation ou non.

Les déposants ont démontré des propriétés remarquables inattendues du comportement des filtres élémentaires à résonance de mode guidé métallo-diélectriques lorsqu'ils sont illuminés en faisceau convergent sur des dimensions de quelques périodes, rendant possible la mise en œuvre de filtres élémentaires « pixellisés », c'est-à-dire dont les dimensions sont de l'ordre de grandeur de celles de chaque détecteur élémentaire, ou « pixel ».

La forme et les dimensions de la tache de focalisation en un point donné du champ ainsi que la profondeur de foyer (ou profondeur de champ image) résultent de façon connue des caractéristiques opto-géométriques de l'optique de formation d'image et de la longueur d'onde. Pour l'estimation des dimensions de la tache de focalisation et de la profondeur de foyer, on pourra prendre une valeur de longueur d'onde prédéterminée, par exemple la longueur d'onde $\lambda_{min}$ correspondant à la longueur d'onde minimale que l'on cherche à détecter avec le dispositif d'imagerie multispectrale dans l'infrarouge.

Par exemple, pour une optique de formation d'image à symétrie de révolution, on pourra prendre comme dimension du diamètre de la tache de focalisation, le diamètre $\phi$ donné par la limite de diffraction à une longueur d'onde $\lambda$ donnée, par exemple la longueur d'onde minimale de détection.

Selon l'invention, au moins un desdits filtres élémentaires présente une acceptance angulaire supérieure ou égale à une valeur prédéterminée, fonction des paramètres opto-géométriques du dispositif, par exemple les paramètres opto-géométriques de l'optique de formation d'images et/ou de la matrice de détection.

Selon l'invention, l'acceptance angulaire $\Delta\theta$ d'un filtre élémentaire est défini par l'angle d'incidence d'une onde plane incidente sur le filtre avec une inclinaison donnée, mesuré par rapport à une direction normale au filtre, et pour lequel la transmission maximale est égale à la moitié de la transmission maximale d'une onde plane identique incidente sur le filtre avec un angle d'incidence nul (incidence normale).

Selon l'invention, ladite valeur prédéterminée est l'angle de bord de champ du dispositif, défini comme l'angle du rayon le plus incliné destiné à atteindre la matrice de détecteurs élémentaires par rapport à la direction normale à ladite matrice de détecteurs élémentaires. Il dépend de la dimension de la matrice de détecteurs élémentaires, du nombre d'ouverture et de la distance focale de l'optique de formation d'image.

Selon un ou plusieurs exemples de réalisation, chacun desdits filtres élémentaires de la matrice de filtres élémentaires présente une acceptance angulaire supérieure ou égale à l'angle de bord de champ du dispositif. En effet, même si l'acceptance angulaire requise pour un filtre élémentaire est plus faible au centre du champ image, on pourra choisir d'optimiser tous les filtres élémentaires de la matrice de filtres élémentaires pour obtenir l'acceptance angulaire la plus grande, c'est-à-dire celle requise pour un filtre élémentaire positionné en bord de champ image.

Selon un ou plusieurs exemples de réalisation, chacun desdites filtres élémentaires présente des dimensions sensiblement identiques à celles d'un détecteur élémentaire. En pratique, comme rappelé ci-dessus, un filtre élémentaire à résonance de mode guidé métallo-diélectrique comprend un guide d'onde en matériau diélectrique et au moins un réseau métallique structuré selon un motif donné, répété avec une période donnée. La dimension d'un filtre élémentaire est donc multiple de la dimension d'un motif et pourra être un peu plus grande ou un peu plus petite qu'un détecteur élémentaire. Ainsi, par dimensions sensiblement identiques, on comprend que l'écart entre une dimension d'un filtre élémentaire et celle d'un détecteur élémentaire (« pixel ») est inférieur à la longueur d'onde centrale de la bande spectrale de transmission du filtre. Il est cependant possible qu'un filtre élémentaire présente une dimension égale à plusieurs fois celle d'un pixel, par exemple entre 2 et 4 fois.

Selon un ou plusieurs exemples de réalisation, les filtres élémentaires de la matrice de filtres élémentaires sont arrangés sous forme de zones, chaque zone comprenant au moins deux filtres élémentaires optimisés pour la transmission passe bande dans des bandes spectrales centrées sur deux longueurs d'onde centrales différentes, et chaque zone présentant des dimensions supérieures à celles de la tache de focalisation. Selon un ou plusieurs exemples de réalisation, l'agencement des filtres élémentaires est identique dans chaque zone.

Selon une première alternative de l'invention, la matrice de filtres élémentaires comprend au moins deux filtres élémentaires étant optimisés pour la transmission passe bande dans des bandes spectrales centrées sur deux longueurs d'onde centrales différentes, égales à deux desdites longueurs d'onde de détection, lesdits au moins deux filtres élémentaires comprenant chacun un filtre élémentaire à résonance de mode guidé de type DMG (abréviation de l'expression anglo-saxonne « Dual metallic Grating »), optimisé pour la transmission passe bande dans une bande spectrale centrée sur une longueur d'onde de détection $\lambda_d$ donnée, comprenant une couche en matériau diélectrique formant un guide d'onde monomode à ladite longueur d'onde de détection $\lambda_d$, et deux réseaux diffractifs métalliques agencés de part et d'autre de la couche en matériau diélectrique. Chaque réseau métallique est structuré selon un motif donné répété avec une période donnée, inférieure à la longueur d'onde de détection et est adapté pour le couplage d'une onde incidente à ladite de longueur d'onde longueur d'onde de détection $\lambda_d$ au mode du guide d'onde. Avantageusement, les périodes sont identiques pour les deux réseaux.

Selon un ou plusieurs exemples de réalisation, le filtre élémentaire à résonance de mode guidé de type DMG est suspendu et les deux réseaux métalliques du filtre élémentaire sont identiques (même métal, même motif, même période).

Selon un ou plusieurs exemples de réalisation, le filtre élémentaire à résonance de mode guidé de type DMG est déposé sur un substrat en matériau diélectrique et les motifs des deux réseaux métalliques du filtre élémentaire sont différents, pour tenir compte des différences d'indice de réfraction des matériaux diélectriques de part et d'autre du guide d'onde (air et substrat par exemple). Avantageusement, les périodes restent identiques pour les deux réseaux.

Selon un ou plusieurs exemples de réalisation, la matrice de filtres élémentaires comprend au moins un filtre élémentaire à résonance de mode guidé de type « bi atome », dans lequel au moins un réseau métallique présente un motif avec au moins deux ouvertures avec des dimensions différentes, par exemples deux fentes de largeurs différentes.

Selon une première alternative de l'invention, la matrice de filtres élémentaires comprend au moins deux filtres élémentaires étant optimisés pour la transmission passe bande dans des bandes spectrales centrées sur deux longueurs d'onde centrales différentes, égales à deux desdites longueurs d'onde de détection, lesdits au moins deux filtres élémentaires comprenant chacun un filtre élémentaire à résonance de mode guidé avec métallisation unique en face avant, comprenant un guide d'onde en matériau diélectrique avec d'un côté un substrat et de l'autre côté un double réseau métallique, les réseaux présentant un motif différent et, selon un ou plusieurs exemples de réalisation, une période identique.

Dans chacun des exemples cités ci-dessus, tous les filtres élémentaires à résonance de mode guidé métallo-diélectriques de la matrice de filtres élémentaires peuvent être identiques ou au contraire, il est possible d'avoir des filtres élémentaires différents, par exemple entre le bord et le centre du champ.

Selon un ou plusieurs exemples de réalisation, les filtres élémentaires de la matrice de filtres élémentaires sont agencés sur un même substrat, ce qui facilite leur fabrication. Ils peuvent également être suspendus.

Selon un deuxième aspect, la présente description concerne un procédé selon la revendication 7.

BREVE DESCRIPTION DES DESSINS

D'autres avantages et caractéristiques de l'invention apparaîtront à la lecture de la description, illustrée par les figures suivantes:

FIG. 1, déjà décrite, une caméra infrarouge multivoies selon l'art antérieur ;

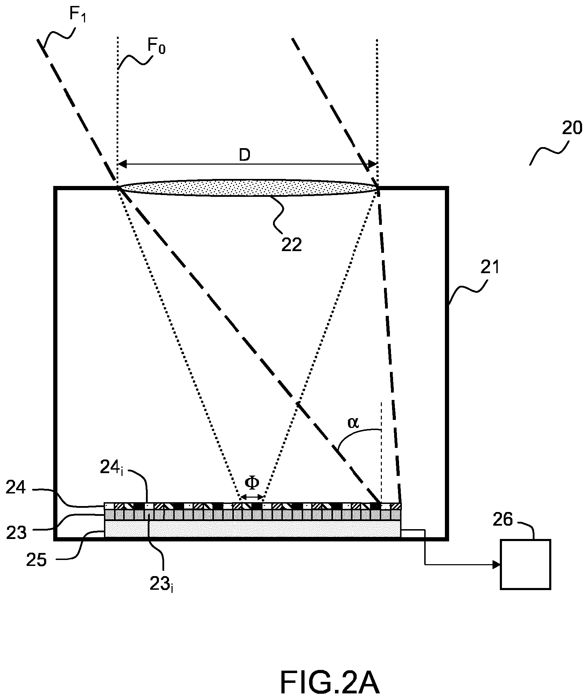

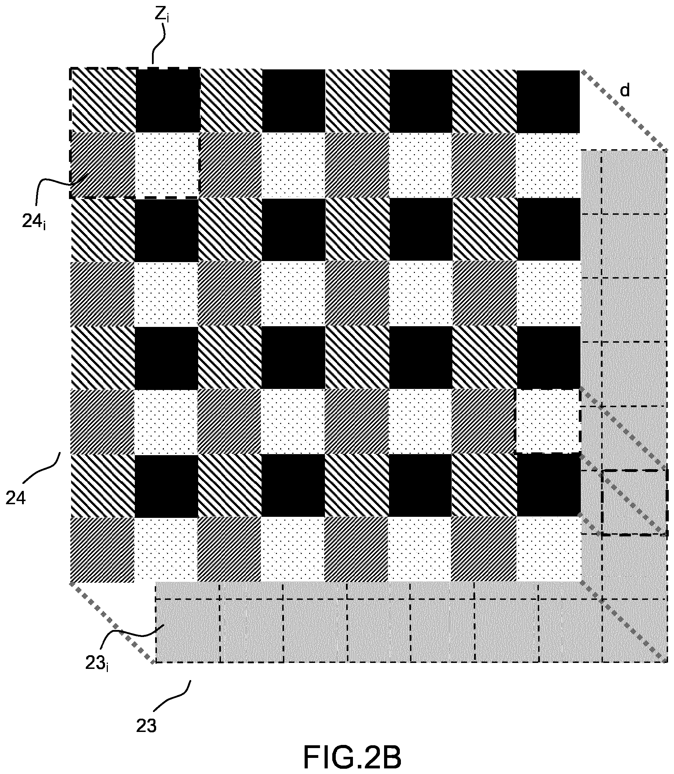

FIG. 2A, un schéma d'un dispositif d'imagerie multispectrale dans l'infrarouge selon un exemple de la présente description ; FIG. 2B, un exemple d'agencement de filtres élémentaires à résonance de mode guidé métallo-diélectriques dans une matrice de filtres élémentaires adaptée pour un dispositif d'imagerie multispectrale dans l'infrarouge selon la présente description ;

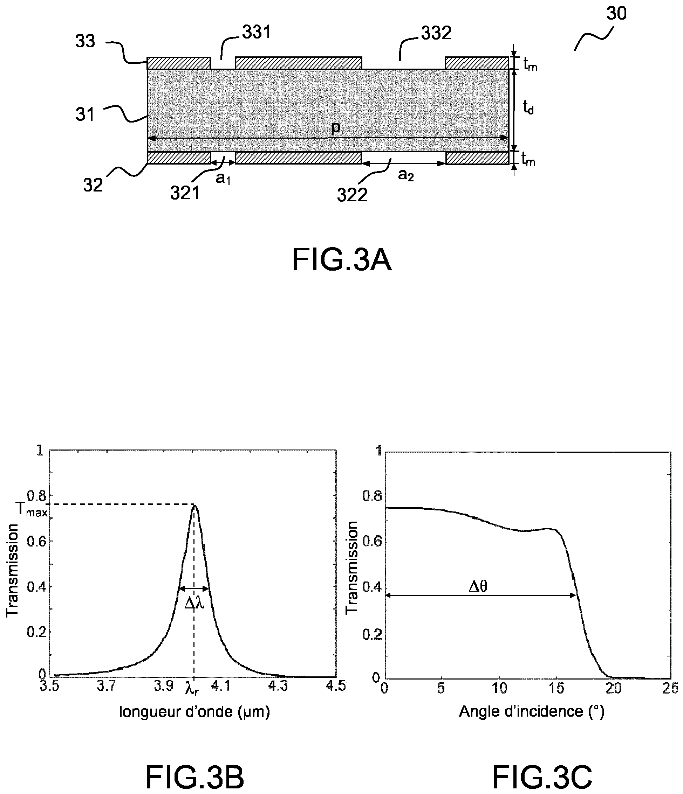

FIG. 3A, un exemple de réalisation d'un filtre GMR métallo-diélectrique de type DMG bi-atome suspendu, adapté pour un dispositif d'imagerie multispectrale dans l'infrarouge selon la présente description ; et FIGS 3B, 3C deux courbes montrant des simulations de transmission en fonction de la longueur d'onde et en fonction de l'angle d'incidence (en ondes planes), dans le cas d'un exemple de filtre DMG suspendu, bi-atome (FIG. 3A);

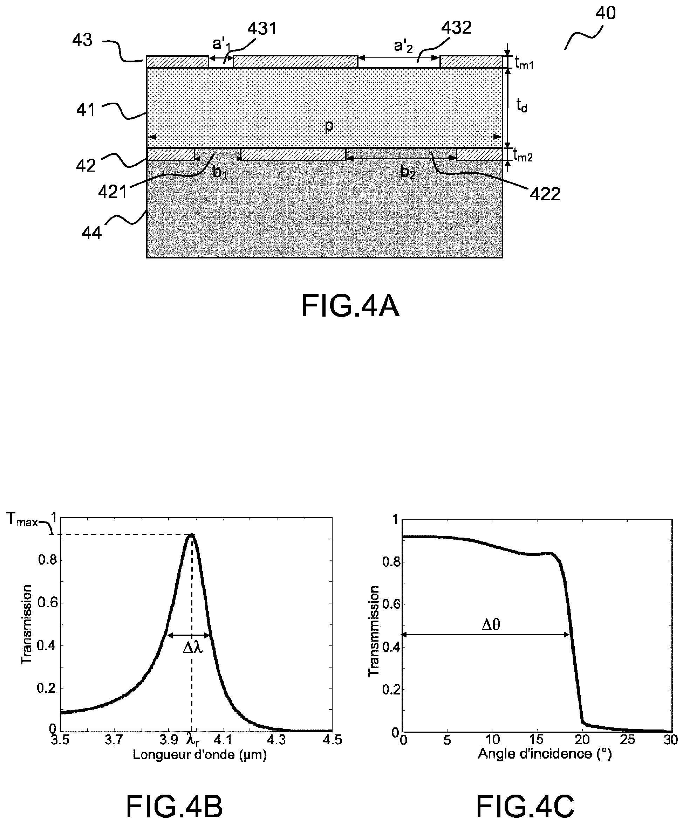

FIG. 4A, un exemple de réalisation d'un filtre GMR métallo-diélectrique de type DMG bi-atomes sur substrat, adapté pour un dispositif d'imagerie multispectrale dans l'infrarouge selon la présente description ; et FIGS 4B, 4C deux courbes montrant des simulations de transmission en fonction de la longueur d'onde et en fonction de l'angle d'incidence (en ondes planes), dans le cas d'un exemple de filtre DMG bi-atome sur substrat (FIG. 4A);

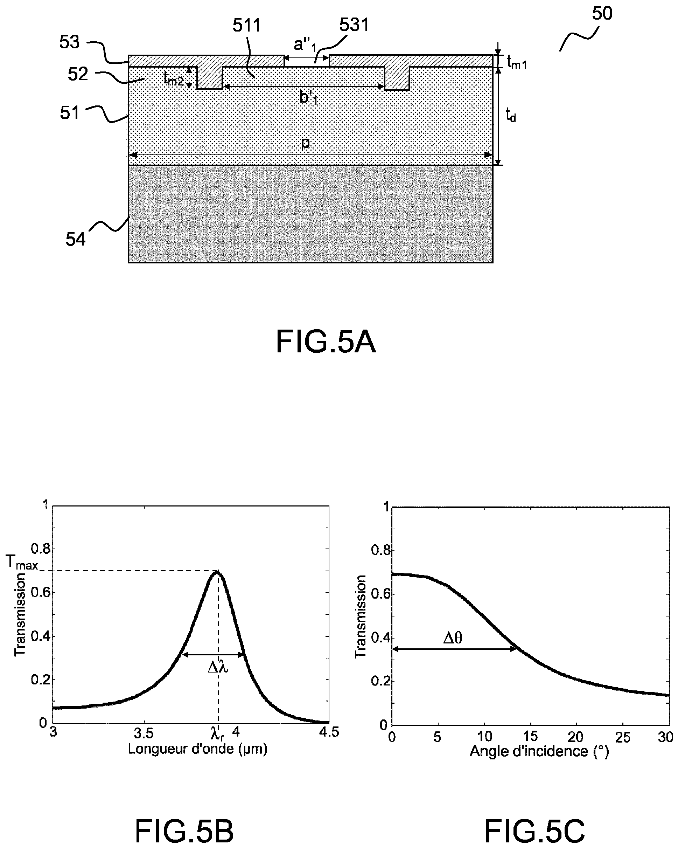

FIG. 5A, un exemple de réalisation d'un filtre GMR métallo-diélectrique de type filtre sur substrat avec métallisation unique en face avant, adapté pour un dispositif d'imagerie multispectrale dans l'infrarouge selon la présente description ; et FIGS 5B, 5C deux courbes montrant des simulations de transmission en fonction de la longueur d'onde et en fonction de l'angle d'incidence (en ondes planes ), dans le cas d'un exemple de filtre sur substrat avec métallisation face avant (FIG. 5A);

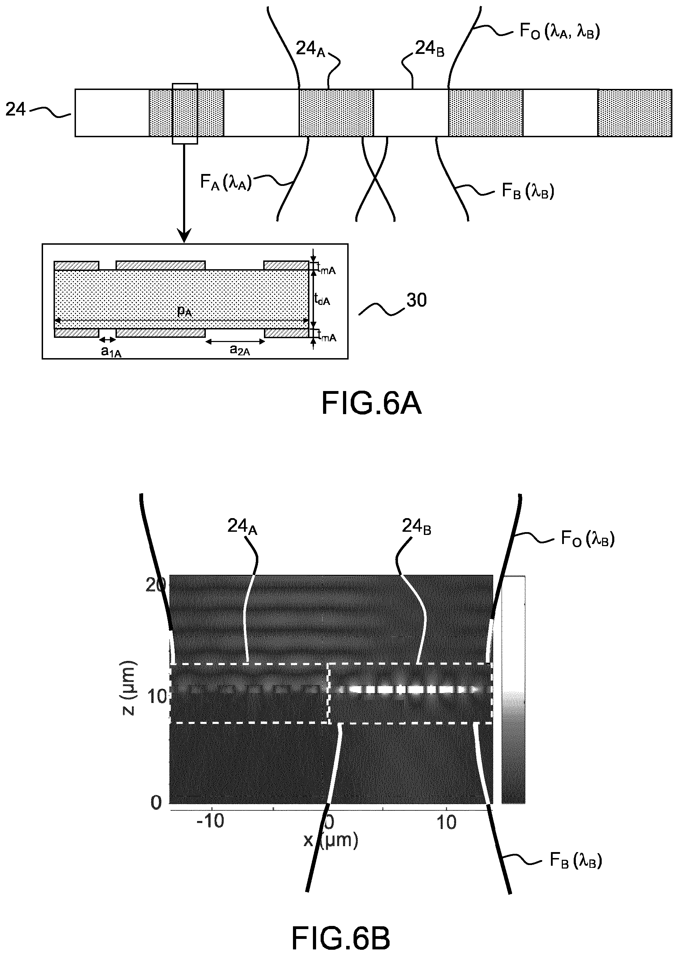

FIGS. 6A et 6B, le schéma d'un exemple de réalisation d'une matrice de filtres adaptée pour un dispositif d'imagerie multispectrale dans l'infrarouge selon la présente description, comprenant des filtres GMR métallo-diélectrique de type DMG bi-atome suspendu, et une simulation montrant le confinement du champ dans la matrice de filtres éclairée en faisceau convergent.

## DESCRIPTION DETAILLEE

La FIG. 2A illustre un exemple d'un dispositif d'imagerie multispectrale dans l'infrarouge selon la présente description. Par imagerie multispectrale, on comprend la formation d'images à au moins deux longueurs d'onde de détection différentes, ou plus précisément dans au moins deux bandes spectrales de détection centrées sur deux longueurs d'onde de détection différentes. La bande spectrale infrarouge est définie dans la présente description comme l'ensemble des longueurs d'onde comprises entre 1 $\mu$m et 15 $\mu$m.

Le dispositif d'imagerie multispectrale dans l'infrarouge, référencé 20 sur la FIG. 2A, comprend, par exemple dans une enceinte 21, une matrice de détection 23 comprenant un ensemble de détecteurs élémentaires 23i, ou « pixels », de dimensions prédéterminées, un circuit de lecture 25 pour le traitement des signaux délivrés par les détecteurs élémentaires 23i, une unité de traitement 26 reliée au circuit de lecture 25 ainsi qu'une matrice 24 de filtres élémentaires 24i à résonance de mode guidé métallo-diélectriques dont un exemple est illustré sur la FIG. 2B. Le dispositif d'imagerie multispectrale dans l'infrarouge comprend en outre une optique de formation d'image 22 agencée dans l'enceinte ou à l'extérieur de l'enceinte et adaptée à la formation d'images dans l'infrarouge.

La matrice de détection adaptée pour l'infrarouge peut comprendre tout type de détecteur matriciel connu (barrette 1D ou détecteur 2D), comme par exemple des détecteurs de type MCT (pour Mercure Cadmium Tellurium), InAs, QWIP (AlGAAs/As/GaAs), superréseaux (InAs/GaSb), ces détecteurs fonctionnant dans une enceinte 21 refroidie. D'autres types de détecteurs adaptés pour le fonctionnement dans un environnement non refroidi peuvent également être utilisés, comme par exemple les microbolomètres.

Typiquement, pour un fonctionnement du dispositif d'imagerie multispectrale entre 1$\mu$m et 15$\mu$m, on pourra travailler avec des détecteurs élémentaires de dimensions comprises entre 15 $\mu$m et 30 $\mu$m, agencés selon une barrette de détection (par exemple sous un format 288 x 4 pixels) ou selon une matrice à deux dimensions (par exemple sous un format 640 x 480 pixels). Les dimensions de la matrice de détection définissent celles du champ image du dispositif de formation d'images.

L'optique de formation d'image 22 est caractérisée par un nombre d'ouverture N et une focale F, avec N = D/F, où D est le diamètre de la pupille de l'optique de formation d'image. L'optique de formation d'images peut comprend une ou une pluralité de lentilles, formées dans des matériaux transparents aux longueurs d'onde d'intérêt, par exemple en germanium.

L'optique de formation d'image 22 est adaptée pour la formation d'images d'une scène sur la matrice de détection 23. En pratique, comme pour tout système optique, on peut définir pour l'optique de formation d'image à une longueur d'onde donnée une tache de focalisation élémentaire en un point du champ image et une profondeur de foyer.

La forme et les dimensions de la tache de focalisation en un point donné du champ ainsi que la profondeur de foyer (ou profondeur de champ image) sont déterminés de façon connue, à une longueur d'onde donnée, par les caractéristiques opto-géométriques de l'optique de formation d'image.

Par exemple, pour une optique de formation d'image à symétrie de révolution, le diamètre de la tache de

focalisation φ peut être défini par la limite de diffraction, à savoir :

$$\phi = 2{,}44\ \lambda\ N \qquad\qquad (1)$$

où N est le nombre d'ouverture de l'optique de formation d'image (N = D/F, avec D diamètre de la pupille de l'optique de formation d'image et F est la focale) et λ est la longueur d'onde. Ainsi par exemple, dans un cas d'un dispositif d'imagerie spectrale avec un nombre d'ouverture N = 3 et pour une longueur d'onde λ = 4,1 μm, le diamètre de la tache de focalisation est de l'ordre de 30μm.

Par ailleurs, la profondeur de foyer, ou profondeur de champ image, dépend essentiellement du nombre d'ouverture de l'optique utilisée et de la longueur d'onde. Elle peut être définie comme l'intervalle mesuré dans l'espace image, dans lequel doit être placée la matrice de détecteurs afin d'obtenir une image nette.

Par exemple, une estimation de la profondeur de foyer $P_f$ peut être donnée par :

$$P_f = 2\ N\ \phi \qquad\qquad (2)$$

Ainsi, pour un nombre d'ouverture N=3 et une tache de focalisation φ = 30μm, on obtient une profondeur de foyer $P_f$=180 μm.

En pratique, selon la présente description, la tache de focalisation pourra recouvrir un ensemble d'au moins deux détecteurs élémentaires juxtaposés lorsque la matrice 23 est formée d'une ligne de détecteurs élémentaires et d'au moins quatre détecteurs élémentaires juxtaposés lorsque la matrice 23 est formée de plusieurs lignes de détecteurs élémentaires. Du fait que le dispositif d'imagerie selon la présente description est destiné à détecter plusieurs longueurs d'onde, on pourra utiliser la longueur d'onde minimale $\lambda_{min}$ de détection pour l'estimation du diamètre φ de la tache de diffraction et de la profondeur de foyer.

Comme illustré sur la FIG. 2B, la matrice 24 de filtres élémentaires à résonance de mode guidé métallo-diélectriques est agencée devant la matrice de détection 23 à une distance d donnée, inférieure à la profondeur de foyer, ce qui permet d'éviter une trop grande divergence des faisceaux au niveau de chaque filtre élémentaire.

Les dimensions des filtres élémentaires sont adaptées pour que chaque tache élémentaire de focalisation formée en chaque point du champ image recouvre au moins deux filtres élémentaires, ces deux filtres élémentaires étant optimisés pour la transmission passe bande dans des bandes spectrales centrées sur deux longueurs d'onde centrales différentes, égales à deux longueurs d'onde de détection. Ainsi, au niveau de chaque tache de focalisation élémentaire, des détecteurs élémentaires reçoivent des flux lumineux filtrés dans des bandes spectrales centrés autour de longueurs d'onde de détection différentes.

A titre d'exemple, on a représenté sur la FIG. 2B un schéma d'une matrice 24 à deux dimensions de filtres élémentaires 24i. Dans cet exemple, on peut définir des zones Zi formées de 4 filtres élémentaires optimisés chacun pour la détection dans une bande spectrale centrée sur une longueur d'onde de détection différente. En pratique, un tache de focalisation de l'optique de formation d'image formée au niveau de la matrice de filtres 24 et calculée par exemple pour la plus petite des longueurs d'onde de détection, pourra recouvrir une zone circulaire inscrite dans le cadre Zi.

En pratique, les dimensions d'un filtre élémentaire peuvent être sensiblement les mêmes que celles d'un détecteur élémentaire, comme cela est illustré sur la FIG. 2B. Mais il est également tout à fait possible qu'un filtre élémentaire soit un peu plus grand ou un peu plus petit qu'un détecteur élémentaire.

Un filtre élémentaire présente des dimensions telles qu'il couvre un groupe de deux détecteurs élémentaires (cas d'une barrette de détection 1D) ou un filtre élémentaire peut présenter des dimensions telles qu'il couvre un groupe de 4 détecteurs élémentaires (cas d'une matrice de détection 2D) tant que la matrice de filtres élémentaires se trouve dans la profondeur de foyer de l'optique de formation d'images et qu'au niveau d'une tache de focalisation élémentaire, il y ait au moins deux filtres élémentaires adaptés à la transmission dans des bandes spectrales centrées sur deux longueurs d'onde de détection distinctes.

De manière générale, on peut définir des zones Zi formées d'un plus grand nombre de filtres élémentaires, les filtres étant identiques ou différents, mais chaque zone Zi comprenant au moins deux filtres élémentaires optimisés pour la transmission passe bande dans des bandes spectrales centrées sur deux longueurs d'onde centrales différentes, égales à deux longueurs d'onde de détection. Les filtres élémentaires peuvent être agencés selon un arrangement donné dans chaque zone Zi. Les zones Zi peuvent être toutes identiques, comme dans l'exemple de la FIG. 2B. Avantageusement, la tache de focalisation est suffisamment petite pour être contenue dans une zone Zi de telle sorte qu'il n'y ait pas de « débordement » d'une zone à l'autre. Par exemple la tache de focalisation est de forme circulaire, inscrite dans une zone Zi.

Comme précisé précédemment, un filtre élémentaire à résonance de mode guidé métallo-diélectriques (GMR) comprend un guide d'onde en matériau diélectrique et au moins un réseau métallique structuré selon un motif donné, répété avec une période donnée, pour le couplage d'une onde incidente aux mode guidé du guide d'onde. Ainsi, même lorsque la dimension d'un filtre élémentaire est sensiblement égale à celle d'un détecteur élémentaire, comme illustré sur la FIG. 2B, comme la dimension d'un filtre élémentaire est multiple en pratique de la dimension d'un motif d'un réseau métallique, il pourra être un peu plus grand ou un peu plus petit qu'un détecteur élémentaire, avec un écart inférieur à la longueur d'onde de détection.

Comme cela apparaît sur la FIG. 2A, les filtres élémentaires $24i$ reçoivent des faisceaux lumineux convergents $F_0$, $F_1$, la convergence des faisceaux en bord de champ (faisceau $F_1$) étant plus importe que celle dans le centre du champ (faisceau $F_0$). On peut définir notamment un angle de bord de champ $\alpha$, défini comme l'angle du rayon le plus incliné destiné à atteindre la matrice de détecteurs élémentaires par rapport à la direction normale à ladite matrice de détecteurs élémentaires. Il dépend de la dimension de la matrice de détecteurs élémentaires, du nombre d'ouverture et de la distance focale de l'optique de formation d'image. Plus précisément, on peut définir l'angle de bord de champ $\alpha$ par :

$$\boldsymbol{\alpha} = \arctan\left(\frac{n_{pix}t_{pix} + D}{2F}\right) \qquad (3)$$

Où $n_{pix}$ est le nombre maximal de pixels de détection (selon une dimension), $t_{pix}$ est le pas du pixel.

Par exemple, pour un nombre de pixels détection sur une ligne $n_{pix}$=640, un pas de pixel $t_{pix}$=15$\mu$m, un diamètre de l'optique de formation D= 25 mm, une distance focale F= 50 mm, on obtient un angle de bord de champ $\alpha$ = 19°

Ainsi, tout ou partie des filtres élémentaires, et notamment les filtres élémentaires positionnés en bord de champ, pourront présenter une acceptance angulaire supérieure ou égale à l'angle de bord de champ du dispositif. Selon l'invention, au moins un desdits filtres élémentaires présente une acceptance angulaire mesurée en ondes planes supérieure ou égale à l'angle de bord de champ du dispositif.

Différents filtres élémentaires à résonance de mode guidé (GMR) métallo-diélectriques connus de l'art antérieur peuvent être utilisés pour la mise en œuvre d'un dispositif d'imagerie multispectrale dans la l'infrarouge selon la présente description.

Le dimensionnement des filtres GMR pour le filtrage spectral dans l'infrarouge dans un dispositif d'imagerie multispectrale selon la présente description pourra comprendre les étapes suivantes.

En fonction des applications, on définit les longueurs d'onde de détection $\lambda_{di}$ ainsi que les largeurs $\Delta\lambda_i$ des bandes spectrales de détection aux longueurs d'onde de détection considérées. Par exemple, pour la détection d'une espèce chimique particulière, il pourra être intéressant de rechercher une largeur de bande spectrale de détection faible (inférieure à 0,5$\mu$m) tandis que pour d'autres applications, par exemple d'évaluation de l'émissivité d'un corps, il pourra être intéressant de rechercher une largeur de bande spectrale de détection plus grande (supérieure à 1$\mu$m).

Les caractéristiques de la matrice de détection sont également fixées en fonction de l'application : barrette de détection ou matrice à 2 dimensions, nombre de pixels ($n_{pix}$) selon chacune direction et taille d'un pixel ($t_{pix}$).

Les caractéristiques opto-géométriques du dispositif, notamment le nombre d'ouverture N et la distance focale F de l'optique de formation d'images sont choisies en fonction de la scène à observer, du détecteur (résolution spatiale) et de l'encombrement maximal requis pour le dispositif.

On définit ci-dessous comment les filtres élémentaires peuvent être choisis et dimensionnés, en fonction des longueurs d'onde de détection $\lambda_{di}$ recherchées, de la largeur $\Delta\lambda_i$ de la bande spectrale de détection à la longueur d'onde de détection considérée et des paramètres opto-géométriques du dispositif de détection. Notamment, on pourra déterminer dans une même matrice de filtres élémentaires un ou plusieurs types de filtres (DMG, bi-atome, etc.), comme cela sera décrit par la suite.

Pour chaque type de filtre, on cherche à déterminer les paramètres géométriques du filtre permettant d'atteindre les caractéristiques optiques recherchées pour le filtre qui sont la transmission maximale $T_{max}$, la longueur d'onde de résonance $\lambda_r$, la largeur de résonance $\Delta\lambda$ et l'acceptance angulaire $\Delta\theta$. En pratique, la longueur d'onde de résonance $\lambda_r$ recherchée, correspondant à la longueur d'onde centre de la bande spectrale de transmission pour laquelle la transmission $T_{max}$ est maximale, sera égale à une longueur d'onde de détection $\lambda_{di}$. La largeur de résonance $\Delta\lambda$ recherchée, correspondant à la largeur à mi-hauteur de la réponse spectrale du filtre en transmission, sera égale à la largeur $\Delta\lambda_i$ de la bande spectrale de détection et l'acceptance angulaire $\Delta\theta$ recherchée pourra être définie en fonction de l'angle de bord de champ $\alpha$ du dispositif (voir équation (3) ci-dessus).

En ce qui concerne l'acceptance angulaire $\Delta\theta$ des filtres élémentaires, on pourra avantageusement la choisir supérieure à l'angle de bord de champ $\alpha$ pour l'ensemble des filtres de la matrice ou tout du moins pour une partie des filtres situés en bord de champ. Si l'acceptance angulaire $\Delta\theta$ est inférieure à l'angle de bord de champ $\alpha$, le filtre continue de fonctionner mais son efficacité diminue puisque la transmission à la résonance $T_{max}$ décroit et le facteur de qualité $Qi = \lambda_{di}/\Delta\lambda_i$ peut être dégradé.

La détermination des paramètres des filtres élémentaires, une fois un type de filtre choisi, pourra comprendre les étapes suivantes : (1) choix des premiers paramètres, (2) vérification des premiers paramètres par simulation numérique (simulation de la transmission en fonction de la longueur d'onde et simulation de la transmission en fonction de l'angle d'incidence) et (3) modification des paramètres en fonction des résultats de la simulation.

Pour l'étape (2) de vérification des premiers paramètres par simulation numérique, une simulation de la transmission du filtre en faisceau convergent peut être effectuée. Elle comprend une décomposition du faisceau convergent incident en ondes planes d'angles d'incidence différents, la simulation de la propagation de chaque onde plane élémentaire et une sommation des ondes planes élémentaires après propagation. Les déposants ont montré cependant qu'une simulation de la transmission du filtre « en ondes planes » pouvait être effectuée, car les paramètres obtenus avec une simulation numérique simplifiée en ondes planes étaient sensiblement similaires à ceux obtenus au moyen d'une simulation de la transmission en faisceaux convergents, pourvu que l'angle d'incidence de l'onde reste dans la gamme de la tolérance angulaire du filtre.

Dans tous les cas, on pourra utiliser différentes méthodes connues pour simuler des réponses de filtres élémentaires à des ondes électromagnétiques incidentes. On peut par exemple utiliser une méthode de calcul modal telle que RCWA (pour « Rigorous coupledwave analysis »), décrite par exemple dans M.G. Moharam et al., JOSAA 12, 1068 (1995). On peut également utiliser des méthodes éléments finis (« FEM » pour « Finite Element Methods ») mises en œuvres par exemple dans le logiciel COMSOL Multiphysics® ou différences finies (« FDTD » pour Finite Difference Time Domain) mises en œuvre dans le logiciel LUMERICAL®. Les courbes présentées dans la suite de la description sont calculées par une méthode de calcul modal, et plus particulièrement en utilisant le code de calcul Reticolo pour Matlab® (P. Hugonin and P. Lalanne, « Reticolo software for grating analysis », Institut d'Optique, Orsay, France (2005)), dans une hypothèse d'ondes planes et de motif unidimensionnel (fentes).

Comme précédemment exposé, un filtre élémentaire à résonance de mode guidé métallo-diélectrique, optimisé pour la transmission passe bande dans une bande spectrale centrée sur une longueur d'onde de résonance $\lambda_r$ donnée, comprend, au sens de la présente description, une couche en matériau diélectrique (indice de réfraction $n_d$ et épaisseur $t_d$) formant un guide d'onde monomode à ladite longueur d'onde, et au moins un réseau diffractif métallique (indice de réfraction $n_m$ et épaisseur $t_m$), structuré selon un motif donné répété avec une période donnée (p), inférieure à ladite longueur d'onde de résonance. Le réseau de diffraction est adapté pour le couplage d'une onde incidente à la longueur d'onde de résonance au mode du guidé. Le motif peut comprendre une ou plusieurs ouvertures de dimensions données, les ouvertures pouvant être bidimensionnelles (croix, ouvertures circulaires par exemple) ou mono dimensionnelles (fentes). Les ouvertures sont remplies d'un matériau diélectrique pouvant être l'air ambiant ou un autre matériau diélectrique comme par exemple le matériau diélectrique formant le guide d'onde ou celui formant le substrat, en fonction des différents types de filtres.

Trois exemples de conceptions de filtres élémentaires à résonance de mode guidé métallo-diélectrique pour la réalisation d'un dispositif d'imagerie multispectrale selon la présente description sont donnés ci-dessous. Ces exemples ne sont pas limitatifs, d'autres géométries étant possibles pour la réalisation de filtres élémentaires à résonance de mode guidé. Dans chaque cas, une méthode similaire pour la définition des paramètres du filtre peut être appliquée.

Un premier exemple est décrit au moyen des FIGS. 3A - 3C.

Sur la FIG. 3A, seul un motif d'un filtre élémentaire 30 de dimension p est représenté. En pratique, le filtre élémentaire comprend une répétition du motif ainsi représenté pour former un réseau de diffraction présentant une période p.

Le filtre élémentaire 30 illustré sur la FIG. 3A est de type DMG (« dual metallic grating ») suspendu. Il comprend une couche en matériau diélectrique 31 formant un guide d'onde monomode à la longueur d'onde de résonance $\lambda_r$, et deux réseaux diffractifs métalliques 32, 33, agencés de part et d'autre de la couche en matériau diélectrique, le tout étant suspendu dans un fluide tel que l'air ou dans le vide. Chaque réseau métallique est structuré selon un motif donné répété avec une période p donnée, inférieure à la longueur d'onde longueur d'onde de résonance. Plus précisément, dans l'exemple de la FIG. 3A, le premier réseau métallique 32 comprend un motif avec deux fentes 321, 322 de largeurs respectives $a_1$ et $a_2$ et le deuxième réseau métallique 33 comprend un motif avec deux fentes 331, 332 de largeurs respectives $a_1$ et $a_2$ identiques à celles des fentes du motif du premier réseau.

Dans l'exemple de la FIG. 3A, les réseaux métalliques sont dits « bi-atomes » car ils présentent deux fentes de largeur différentes par motif. Un tel type de filtre élémentaire DMG, bi-atome, est décrit par exemple dans E. Sakat *et al.* 2013. A noter cependant que si ces filtres sont intéressants du point de vue de l'acceptance angulaire, il est tout à fait possible aussi de concevoir un dispositif d'imagerie multispectrale mettant en œuvre des filtres élémentaires DMG suspendus « mono-atome », c'est-à-dire dans lesquels un motif d'un réseau diffractif métallique ne comprend qu'une fente, comme décrit par exemple dans C. Tardieu et al., Optics Letters 40, 4 (2015).

Dans l'étape (1) de détermination des premiers paramètres, on choisit tout d'abord l'épaisseur et l'indice de réfraction $t_g$ et $n_g$ du guide d'onde. $t_g$ et $n_g$ sont choisis suffisamment faibles pour que le guide d'onde soit monomode à la longueur d'onde de résonance $\lambda_r$ désirée. Ils respectent ainsi la condition :

$$0 < \frac{2}{\lambda_r t_d \left(n_d^2 - 1\right)^{1/2}} < 1 \qquad (4)$$

On règle ensuite la période p et l'indice du diélectrique $n_g$ afin qu'une onde plane sous incidence normale à la longueur d'onde de résonance soit diffractée dans seulement 3 ordres dans le guide d'onde et seulement dans l'ordre 0 dans l'espace libre (milieu incident ou milieu de transmission). Pour cela on s'appuie sur les lois connues des réseaux en transmission.

On peut ensuite ajuster la largeur des fentes, sachant qu'on recherche dans ce cas deux fentes de largeurs différentes ($a_1 \neq a_2$). Des fentes larges permettent d'obtenir une forte transmission à la résonance mais diminuent le facteur de qualité. Pour obtenir une résonance plus fine, il faut des fentes moins larges.

En pratique, les déposants ont montré qu'aux longueurs d'onde de détection d'intérêt (par exemple entre $3\mu m$ et $5\mu m$), les paramètres des filtres peuvent être choisis dans les fourchettes de valeurs suivantes :

Réseaux métalliques 32,33 en or (Au), argent (Ag), ou cuivre (Cu)
$t_m$ compris entre $\lambda_r/100$ et $\lambda_r/10$

$$p < \lambda_r \ ;$$

$$a_1 < \lambda_r/4, \ a_2 < \lambda_r/4, \ a_1 \neq a_2 \ ;$$

Matériau diélectrique, par exemple en carbure de silicium (SiC) ou nitrure de silicium (SiN)
$t_d$ compris entre $\lambda_r/20$ et $\lambda_r/2$ ;
Pour une gamme spectrale aux plus hautes longueurs d'onde, par exemple sur la gamme 8-12 $\mu m$, les dimensions typiques seront naturellement plus grandes.

Dans l'étape (2), on vérifie par des simulations numériques les caractéristiques optiques de chaque filtre avec les premiers paramètres choisis.

Pour cela, on calcule le spectre en transmission de ce filtre afin d'obtenir la transmission maximale sur la gamme de longueur d'onde simulée et sa position en longueur d'onde (FIG. 3B), correspondant respectivement à la valeur de la transmission à la résonance $T_{max}$ du filtre et à la longueur d'onde de résonance $\lambda_r$. On obtient aussi la largeur à mi-hauteur $\Delta\lambda$ de la résonance. On calcule aussi (FIG. 3B) l'évolution de la transmission pour la longueur d'onde fixe $\lambda_r$ lorsqu'on modifie l'angle d'incidence de l'onde plane. On en déduit la tolérance angulaire du filtre $\Delta\theta$ qui correspond à l'angle pour lequel la transmission chute à la moitié de sa valeur sous incidence normale.

Les courbes illustrées sur les FIGS. 3A et 3B illustrent ainsi la transmission en fonction de la longueur d'onde et la transmission en fonction de l'angle d'incidence pour un filtre à résonance de mode guidé tel que celui décrit sur la FIG. 3A avec les paramètres suivants : période p = 3 $\mu m$, $a_1$ = 0,2 $\mu m$, $a_2$ = 0,7 $\mu m$, $t_m$ = 0,1 $\mu m$ et $t_d$ = 0,65 $\mu m$, $n_d$ = 2,15 (SiNx) et $n_m$ est donné par un modèle de Drude de l'or.

Les simulations donnent pour ce filtre : $\lambda_r$ = 4,01 $\mu m$, $T_{max}$ = 75%, $\Delta\theta$ = 17° et $\Delta\lambda$ = 120 nm.

L'étape (3) de conception des filtres comprend une modification éventuelle des paramètres pour l'optimisation en fonction des caractéristiques recherchées. On peut obtenir par exemple une longueur d'onde de résonance plus faible en diminuant la période p. On peut obtenir une tolérance angulaire plus importante en augmentant l'indice du guide. On peut obtenir une résonance plus fine spectralement en diminuant la largeur des deux fentes. Toutefois, à chaque fois qu'on modifie un paramètre pour changer la valeur d'une des caractéristiques optiques, il faut réajuster les autres paramètres sans quoi on risque de dégrader une autre des caractéristiques optiques. Il est aussi possible d'utiliser un algorithme d'optimisation pour trouver les meilleurs paramètres, comme par exemple l'optimisation par essaims particulaires (Mehrdad Shokooh-Saremiand et al., "Particle swarm optimization and its application to the design of diffraction grating filters," Opt. Lett. 32, 894-896 (2007) ).

Un deuxième exemple est décrit au moyen des FIGS. 4A - 4C.

Sur la FIG. 4A comme sur la FIG. 3A, seul un motif d'un filtre élémentaire 40 de dimension p est représenté. En pratique, le filtre élémentaire comprend une répétition du motif ainsi représenté pour former un réseau de diffraction présentant une période p.

Le filtre élémentaire 40 illustré sur la FIG. 4A est de type DMG (« dual metallic grating ») bi-atomes, avec substrat. Il comprend une couche en matériau diélectrique 41 (épaisseur $t_d$, indice de réfraction $n_d$) formant un guide d'onde monomode à la longueur d'onde de résonance $\lambda_r$, et deux réseaux diffractifs métalliques 42, 43 (épaisseurs $t_{m1}$, $t_{m1}$, indices de réfraction $n_{m1}$, $n_{m2}$), agencés de part et d'autre de la couche en matériau diélectrique. Il comprend en outre un substrat 44 d'indice de réfraction $n_{sub}$ ($n_{sub} < n_d$) sur lequel sont déposés dans cet exemple la couche en matériau diélectrique 41 et le réseau diffractif métallique 42. Chaque réseau métallique est structuré selon un motif donné, le motif étant répété pour chaque réseau avec une période p donnée inférieure à la longueur d'onde de résonance. Plus précisément, dans l'exemple de la FIG. 4A, le premier réseau métallique 32 comprend un motif avec deux fentes 421, 422 de largeurs respectives $b_1$ et $b_2$ et le deuxième réseau métallique 43 comprend un motif avec deux fentes 431, 432 de largeurs respectives $a'_1$ et $a'_2$.

En pratique, on peut partir d'un filtre DMG suspendu tel que décrit sur la FIG. 3A pour une première estimation des paramètres en vu d'obtenir les caractéristiques recherchées. On choisit alors un substrat adapté et on ajuste les largeurs des fentes du réseau en contact avec le substrat. On cherche un substrat d'indice optique le plus faible possible et un guide d'onde d'indice optique élevé afin de conserver un guide d'onde monomode. On choisit la période p de telle sorte qu'il n'y ait que l'ordre 0 diffracté par les réseaux qui se propage dans le substrat, comme pour le guide suspendu. Dans cet exemple, contrairement à l'exemple de la FIG. 3A, les largeurs et/ou épaisseurs des fentes du réseau 42 sont différentes de celles du réseau 43 pour compenser le changement d'indice du substrat. Un tel filtre est décrit par exemple dans C. Tuambilangana et al., Optics Express 23, 25 (2015).

Comme précédemment, bien que des réseaux métalliques bi-atomes soient présentés dans l'exemple de la FIG. 4A, il serait également possible d'optimiser les paramètres pour des filtres DMG mono-atomes sur substrat.

Les courbes illustrées sur les FIGS. 4A et 4B (étape 2) illustrent la transmission en fonction de la longueur d'onde et la transmission en fonction de l'angle d'incidence pour un filtre à résonance de mode guidé tel que celui décrit sur la FIG. 4A avec les paramètres suivants : période p = 2 $\mu$m, $a_1$ = 0,12 $\mu$m, $a_2$ = 0,62 $\mu$m, $b_1$ = 0,15 $\mu$m, $b_2$ = 0,65 $\mu$m, $t_{m1}$ = 0,1 $\mu$m, $t_{m2}$ = 0,05 $\mu$m, $t_d$ = 0,6 $\mu$m, $n_g$ = 2,84 (SiC) et $n_m$ est donné par un modèle de Drude de l'or.

Les simulations donnent pour ce filtre : $\lambda_r$ = 3,98 $\mu$m, $T_{max}$ = 92%, $\Delta\theta$ = 20° et $\Delta\lambda$ = 160 nm.

Une étape (3) de modification des paramètres pour optimiser les paramètres en fonction des caractéristiques recherchées peut être effectuée comme précédemment décrit.

Un deuxième exemple est décrit au moyen des FIGS. 5A - 5C.

Sur la FIG. 5A comme sur la FIG. 3A, seul un motif d'un filtre élémentaire 50 de dimension p est représenté. En pratique, le filtre élémentaire comprend une répétition du motif ainsi représenté pour former un réseau de diffraction présentant une période p.

Le filtre élémentaire 50 illustré sur la FIG. 5A est de type métallisation unique en face avant, avec substrat. Il comprend une couche en matériau diélectrique 51 (épaisseur $t_d$, indice de réfraction $n_d$) formant un guide d'onde monomode à la longueur d'onde de résonance $\lambda_r$, et deux réseaux diffractifs métalliques 52, 33 (épaisseur $t_{m1 \text{ et }} t_{m2}$, indice de réfraction $n_m$), agencés cette fois-ci du même côté de la couche en matériau diélectrique. Il comprend en outre un substrat 54 d'indice de réfraction $n_{sub}$ ($n_{sub} < n_g$) sur lequel est déposé la couche en matériau diélectrique 51 (substrat du côté opposé au côté portant les réseaux). Chaque réseau métallique est structuré selon un motif donné, répété pour chaque réseau avec une période p donnée , inférieure à la longueur d'onde de résonance. Plus précisément, dans l'exemple de la FIG. 5A, le premier réseau métallique 52 comprend un motif avec deux fentes 521 de largeurs identiques $b'_1$ et le deuxième réseau métallique 53 comprend un motif avec une fente unique 531 de largeur $a''_1$.

En pratique, on peut partir également d'un filtre DMG suspendu tel que décrit sur la FIG. 3A pour une première estimation des paramètres en vu d'obtenir les caractéristiques recherchées (mais dans une configuration mono-atome). On choisit alors un substrat adapté et on ajuste la largeur et l'épaisseur de la fente unique de chaque réseau pour changer le facteur de qualité et la tolérance angulaire.

Les courbes illustrées sur les FIGS. 5A et 5B (étape 2) illustrent la transmission en fonction de la longueur d'onde et la transmission en fonction de l'angle d'incidence pour un filtre à résonance de mode guidé tel que celui décrit sur la FIG. 5A avec les paramètres suivants : période p = 1,5 $\mu$m, $a''_1$ = 0,2 $\mu$m, $b'_1$ = 0,1 $\mu$m, $t_{m1}$ = 0,1 $\mu$m, $t_{m2}$ = 0,13 $\mu$m, $t_d$ = 0,63 $\mu$m, $n_d$ = 2,15 (SiNx) et $n_m$ est donné par un modèle de Drude de l'or.

Les simulations donnent pour ce filtre : $\lambda_r$ = 3,89 $\mu$m, $T_{max}$ = 70%, $\Delta\theta$ = 15° et $\Delta\lambda$ = 320 nm.

Une étape (3) de modification des paramètres pour optimiser les paramètres en fonction des caractéristiques recherchées peut être effectuée comme précédemment décrit.

Les déposants ont démontré que les filtres GMR métallo-diélectriques décrits ci-dessus peuvent opérer en faisceau convergent, et sur des surfaces de la dimension du pixel de détection.

La FIG. 6A illustre ainsi une vue en coupe d'une matrice 24 de filtres élémentaires à résonance de mode guidé comprenant dans cet exemple des filtres élémentaires $24_A$, $24_B$, adaptés chacun pour la transmission résonante dans une bande spectrale centrée sur les longueurs d'ondes $\lambda_A$, $\lambda_B$ respectivement. On suppose dans cet exemple une matrice 24 formée d'une ligne de filtres élémentaires et adapté pour le filtrage dans un dispositif d'imagerie multispectrale infrarouge équipé d'une barrette de détecteurs élémentaires. Cependant, il pourrait tout aussi bien s'agir d'une matrice 2D de filtres élémentaires adaptée pour le filtrage dans un dispositif d'imagerie multispectrale infrarouge équipé d'une matrice 2D de détecteurs élémentaires. Chaque filtre comprend un réseau de diffraction formé de quelques périodes d'un motif de telle sorte que les dimensions d'un filtre soient sensiblement les mêmes que les dimensions d'un pixel.

On étudie le comportement des filtres sous faisceau focalisé $F_0$, le faisceau lumineux $F_0$ comportant toute une gamme de longueurs d'onde, dont les longueurs d'onde $\lambda_A$, $\lambda_B$. Les déposants ont montré que l'étalement des champs électriques et magnétiques dans le guide d'onde à la résonance est limité, le champ électromagnétique étant localisé à la longueur d'onde $\lambda_A$ dans le filtre $24_A$ et à la longueur d'onde $\lambda_B$ dans le filtre $24_B$. Ainsi en sortie de la matrice de filtres, on obtient respectivement des faisceaux $F_a$ et $F_b$ aux longueurs d'onde centrales $\lambda_A$ et $\lambda_B$.

La FIG. 6B montre ainsi les résultats d'une simulation numérique calculant l'intensité du champ magnétique au sein d'un filtre élémentaire, la simulation étant réalisée avec une matrice de filtres élémentaires telle que représentée sur la FIG. 6A. Pour cette simulation, chaque filtre $24_A$, $24_B$ est choisi de type DMG bi-atomes suspendu, comme illustré par exemple sur la FIG. 3A, optimisé respectivement à des longueurs d'onde de résonance $\lambda_A = 4\ \mu m$ et $\lambda_B = 4,7\ \mu m$. L'encart 30 sur la FIG. 6A illustre dans le détail un filtre $24_A$, limité à un motif. Les caractéristiques des filtres sont les suivantes. Pour le filtre $24_A$, période $p_A = 3\ \mu m$, nombre de périodes = 5, largeurs des fentes $a_{1A} = 0,2\ \mu m$, $a_{2A} = 0,5\ \mu m$. Pour le filtre $24_B$, période $p_A = 3,7\ \mu m$, nombre de périodes = 4, largeurs des fentes $a_{1B} = 0,1\ \mu m$, $a_{2B} = 0,7\ \mu m$. Pour les deux filtres $24_A$, $24_B$, la simulation est effectuée avec une couche en matériau diélectrique formée en SiN et un réseau métallique en Au. Par ailleurs, $t_{mA} = t_{mB} = 0,1\ \mu m$ et $t_{dA} = t_{dB} = 0,65\ \mu m$.

Pour la simulation, les filtres sont éclairés avec un faisceau $F_0$ focalisé de demi-angle d'ouverture 9° et à la longueur d'onde $\lambda_B$. On constate que bien qu'il s'agisse de filtres à résonance de mode guidé, le champ électromagnétique est bien localisé dans le filtre B et que lui seul transmet le rayonnement incident.

Une matrice de filtres élémentaires à résonance de mode guidé métallo-diélectriques adapté pour un dispositif d'imagerie multispectrale selon la présente description peut être fabriquée selon les procédés connus décrits par exemple dans les articles référencés dans la présente description. La matrice peut être déposée sur un substrat ou suspendue.

L'agencement de la matrice de filtres élémentaires à proximité de la matrice de détecteurs élémentaires peut ensuite se faire de différentes façons. La matrice de filtres élémentaires peut par exemple être disposée sans collage avec des cales. Elle peut également être collée, au moyen d'une colle transparente dans la gamme des longueurs d'onde de filtrage. Pour prévenir les reflets aux interfaces au niveau du substrat ou de la colle, une couche antireflet peut être ajoutée si besoin. Le collage peut être fait de plusieurs manières. Par exemple en retournant le filtre et en collant la partie supérieure avec les réseaux à la matrice de détecteurs. Ou, selon un autre exemple, dans le cas d'un filtre sur substrat dont l'épaisseur typique, supérieure à 300 $\mu m$, est généralement plus grande que la profondeur de foyer, on peut amincir le substrat via un polissage mécanique ou une gravure chimique et coller le substrat à la matrice de détecteurs.

Bien que décrite à travers un certain nombre d'exemples de réalisation détaillés, le dispositif et le procédé d'imagerie multispectrale infrarouge selon la présente description comprennent différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent.

**Revendications**

1. Dispositif (20) d'imagerie multispectrale dans l'infrarouge adapté pour la détection à au moins une première et une deuxième longueur d'onde de détection comprenant :

   - une matrice de détection (23) comprenant un ensemble de détecteurs élémentaires (23i) de dimensions prédéterminées formant un champ image de dimensions données;
   - une optique (22) de formation d'image présentant un nombre d'ouverture (N) et une distance focale (F) donnés, adaptés pour la formation en tout point du champ image d'une tache élémentaire de focalisation, ladite tache de focalisation recouvrant un ensemble d'au moins deux détecteurs élémentaires juxtaposés;
   - une matrice (24) de filtres élémentaires à résonance de mode guidé métallo-diélectriques (24i), agencée devant la matrice de détection (23) à une distance inférieure à une profondeur de foyer de l'optique de formation d'image,

   les dimensions des filtres élémentaires étant adaptées de telle sorte que chaque tache élémentaire de focalisation formée en chaque point du champ image recouvre au moins deux filtres élémentaires,
   lesdits au moins deux filtres élémentaires étant optimisés pour la transmission passe bande dans des bandes spectrales centrées sur deux longueurs d'onde centrales différentes, égales à deux desdites longueurs d'onde de détection,
   lesdits au moins deux filtres élémentaires comprenant chacun un filtre élémentaire à résonance de mode guidé de type DMG comprenant une couche en matériau diélectrique (31, 41, 51) formant un guide d'onde monomode à la longueur d'onde de détection associée, et deux réseaux métalliques agencés de part et d'autre ou un filtre élémentaire à résonance de mode guidé avec métallisation unique en face avant, comprenant un guide d'onde en matériau diélectrique avec d'un côté un substrat et de l'autre côté un double réseau métallique,
   au moins un desdits filtres élémentaires présentant une acceptance angulaire mesurée en ondes planes supérieure ou égale à l'angle de bord de champ du dispositif, où l'angle de bord de champ est défini comme l'angle du rayon le plus incliné destiné à atteindre la matrice de détecteurs élémentaires par rapport à la direction normale à ladite matrice de détecteurs élémentaires, et pour lequel une transmission maximale est égale à la moitié d'une transmission maximale d'une onde plane identique incidente sur au moins un desdits filtres élémentaire avec un angle d'incidence nul.

2. Dispositif d'imagerie multispectrale dans l'infrarouge selon la revendication précédente, dans lequel chacun desdites filtres élémentaires présente des dimensions sensiblement identiques à celles d'un détecteur élémentaire.

3. Dispositif d'imagerie multispectrale dans l'infrarouge selon l'une quelconque des revendications précédentes, dans lequel lesdits filtres élémentaires (24i) de la matrice (24) de filtres élémentaires sont arrangés sous forme de zones (Zi), chaque zone comprenant au moins deux filtres élémentaires optimisés pour la transmission passe bande dans des bandes spectrales centrées sur deux longueurs d'onde centrales différentes, et présentant des dimensions supérieures à celles de la tache de focalisation.

4. Dispositif d'imagerie multispectrale dans l'infrarouge selon l'une des revendications précédentes , dans lequel lesdits au moins deux filtres élémentaires comprennent chacun le filtre élémentaire à résonance de mode guidé de type DMG et dans lequel ledit filtre élémentaire à résonance de mode guidé de type DMG est suspendu et les deux réseaux métalliques sont identiques.

5. Dispositif d'imagerie multispectrale dans l'infrarouge selon l'une des revendications précédentes, dans lequel lesdits au moins deux filtres élémentaires comprennent chacun le filtre élémentaire à résonance de mode guidé de type DMG et dans lequel ledit filtre élémentaire à résonance de mode guidé de type DMG est déposé sur un substrat en matériau diélectrique et les deux réseaux métalliques du filtre élémentaire sont différents.

6. Dispositif d'imagerie multispectrale dans l'infrarouge selon l'une quelconque des revendications précédentes, dans lequel lesdits au moins deux filtres élémentaires comprennent chacun le filtre élémentaire à résonance de mode guidé de type DMG, et ledit filtre élémentaire à résonance de mode guidé de type DMG comprend au moins un filtre élémentaire à résonance de mode guidé de type « bi atome », dans lequel ledit au moins un réseau métallique présente un motif avec au moins deux ouvertures de dimensions différentes.

7. Procédé d'imagerie multispectrale dans l'infrarouge adapté pour la détection à au moins une première et une deuxième longueur d'onde de détection comprenant :

   - la formation d'une image d'une scène au moyen d'une optique de formation d'image d'ouverture (N) donnée et l'acquisition de ladite image au moyen d'une matrice de détection comprenant un ensemble de détecteurs élémentaires de dimensions prédéterminées formant un champ image de dimensions données, l'optique de formation d'image (22) formant en tout point du champ image une tache élémentaire de focalisation recouvrant un ensemble d'au moins deux détecteurs élémentaires juxtaposés;
   - le filtrage de faisceaux lumineux focalisés par ladite optique de formation d'image au moyen d'une matrice (24) de filtres élémentaires à résonance de mode guidé métallo-diélectriques, agencée devant la matrice de détection (23) à une distance inférieure à une profondeur de foyer de l'optique de formation d'image de telle sorte que chaque tache élémentaire de focalisation formée en chaque point du champ image recouvre au moins deux filtres élémentaires, lesdits au moins deux filtres élémentaires étant optimisés pour la transmission passe bande dans des bandes spectrales centrées sur deux longueurs d'onde centrales différentes, égales à deux desdites longueurs d'onde de détection,

   lesdits au moins deux filtres élémentaires comprenant chacun un filtre élémentaire à résonance de mode guidé de type DMG comprenant une couche en matériau diélectrique (31, 41, 51) formant un guide d'onde monomode à la longueur d'onde de détection associée, et deux réseaux métalliques agencés de part et d'autre ou un filtre élémentaire à résonance de mode guidé avec métallisation unique en face avant, comprenant un guide d'onde en matériau diélectrique avec d'un côté un substrat et de l'autre côté un double réseau métallique,
   au moins un desdits filtres élémentaires présentant une acceptance angulaire mesurée en ondes planes supérieure ou égale à l'angle de bord de champ du dispositif, où l'angle de bord de champ est défini comme l'angle du rayon le plus incliné destiné à atteindre la matrice de détecteurs élémentaires par rapport à la direction normale à ladite matrice de détecteurs élémentaires, et pour lequel une transmission maximale est égale à la moitié d'une transmission maximale d'une onde plane identique incidente sur au moins un desdits filtres élémentaire avec un angle d'incidence nul.

**Patentansprüche**

1. Vorrichtung (20) zur multispektralen Bildgebung im Infrarotbereich, die für das Erfassen bei mindestens einer ersten und einer zweiten Erfassungswellenlänge angepasst ist, umfassend:

   - eine Erfassungsmatrix (23) umfassend eine Anordnung von Sensorelementen (23i) mit vorbestimmten Abmessungen, die ein Bildfeld mit gegebenen Abmessungen bilden;
   - eine Optik (22) der Bilderzeugung mit einer gegebenen Blendenanzahl (N) und Brennweite (F), die angepasst sind zum Bilden eines elementaren Fokussierungsflecks an jedem Punkt des Bildfeldes, wobei dieser Fokussierungsfleck eine Anordnung von mindestens zwei nebeneinander angeordneten Sensorelementen überdeckt;
   - eine Matrix (24) aus metallisch-dielektrischen elementaren Filtern (24i) mit geführter Modenresonanz, die vor der Erfassungsmatrix (23) in einem Abstand angeordnet ist, der kleiner ist als eine Fokustiefe der Optik der Bilderzeugung,

      wobei die Abmessungen der elementaren Filter so angepasst sind, dass jeder elementare Fokussierungsfleck, der an jedem Punkt des Bildfeldes gebildet wird, mindestens zwei elementare Filter überdeckt,
      wobei die mindestens zwei elementaren Filter für die Bandpassübertragung in den Spektralbändern optimiert sind, die auf zwei verschiedenen Mittenwellenlängen zentriert sind, die gleich den zwei Erfassungswellenlängen sind,
      wobei die mindestens zwei elementaren Filter jeweils einen elementaren Filter mit geführter Modenresonanz vom DMG-Typ, umfassend eine Schicht aus dielektrischem Material (31, 41, 51), die einen Singlemode-Wellenleiter mit einer zugehörigen Erfassungswellenlänge bildet, und zwei Metallgitter, die auf beiden Seiten angeordnet sind, oder einen elementaren Filter mit geführter Modenresonanz mit einer einzigen Metallisierung auf der Vorderseite, umfassend einen Wellenleiter aus dielektrischem Material mit einem Substrat auf der einen Seite und einem doppelten Metallgitter auf der anderen Seite, umfassen,
      wobei mindestens einer der elementaren Filter eine in ebenen Wellen gemessene Winkelakzeptanz aufweist, die größer oder gleich dem Feldrandwinkel der Vorrichtung ist, wobei der Feldrandwinkel als der Winkel des am stärksten geneigten Strahls, der die Sensorelementmatrix erreichen soll, in Bezug auf die Normalenrichtung zu dieser Sensorelementmatrix definiert ist, und bei dem eine maximale Übertragung gleich der Hälfte einer maximalen Übertragung einer identischen ebenen Welle ist, die unter einem Einfallswinkel von null auf mindestens eines der elementaren Filter auftrifft.

2. Vorrichtung zur multispektralen Bildgebung im Infrarotbereich nach dem vorstehenden Anspruch, wobei jedes der elementaren Filter im Wesentlichen die gleichen Abmessungen wie ein Sensorelement aufweist.

3. Vorrichtung zur multispektralen Bildgebung im Infrarotbereich nach einem der vorstehenden Ansprüche, wobei die elementaren Filter (24i) der Matrix (24) aus elementaren Filtern in Form von Zonen (Zi) angeordnet sind, wobei jede Zone mindestens zwei elementare Filter umfasst, die für die Bandpassübertragung in den Spektralbändern, die auf zwei verschiedenen Mittenwellenlängen zentriert sind, optimiert sind und Abmessungen aufweisen, die größer sind als die des Fokussierungsflecks.

4. Vorrichtung zur multispektralen Bildgebung im Infrarotbereich nach einem der vorstehenden Ansprüche, wobei die mindestens zwei elementaren Filter jeweils den elementaren Filter mit geführter Modenresonanz vom DMG-Typ umfassen und wobei der elementare Filter mit geführter Modenresonanz vom DMG-Typ aufgehängt ist und die beiden Metallgitter identisch sind.

5. Vorrichtung zur multispektralen Bildgebung im Infrarotbereich nach einem der vorstehenden Ansprüche, wobei die mindestens zwei elementaren Filter jeweils den elementaren Filter mit geführter Modenresonanz vom DMG-Typ umfassen und wobei der elementare Filter mit geführter Modenresonanz vom DMG-Typ auf einem Substrat aus dielektrischem Material aufgebracht ist und die beiden Metallgitter des elementaren Filters unterschiedlich sind.

6. Vorrichtung zur multispektralen Bildgebung im Infrarotbereich nach einem der vorstehenden Ansprüche, wobei die mindestens zwei elementaren Filter jeweils den elementaren Filter mit geführter Modenresonanz vom DMG-Typ umfassen und der elementare Filter mit geführter Modenresonanz vom DMG-Typ mindestens einen elementaren Filter mit geführter Modenresonanz vom "Bi-Atom"-Typ umfasst, wobei das mindestens eine Metallgitter ein Muster mit mindestens zwei Blenden mit unterschiedlichen Abmessungen aufweist.

7. Verfahren zur multispektralen Bildgebung im Infrarotbereich, das zum Erfassen bei mindestens einer ersten und einer zweiten Erfassungswellenlänge angepasst ist, umfassend:

- Bilden eines Bildes einer Szene mittels einer Optik der Bilderzeugung mit einer gegebenen Blende (N) und Erfassen des Bildes mittels einer Erfassungsmatrix, die eine Anordnung von Sensorelementen mit vorbestimmten Abmessungen umfasst, die ein Bildfeld mit gegebenen Abmessungen bilden, wobei die Optik der Bilderzeugung (22) an jedem Punkt des Bildfeldes einen elementaren Fokussierungsfleck bildet, der eine Anordnung von mindestens zwei nebeneinander angeordneten Sensorelementen überdeckt;
- Filtern von durch die Optik der Bilderzeugung fokussierten Lichtstrahlen mittels einer Matrix (24) aus metallisch-dielektrischen elementaren Filtern mit geführter Modenresonanz, die vor der Erfassungsmatrix (23) in einem Abstand angeordnet ist, der kleiner ist als eine Fokustiefe der Optik der Bilderzeugung, so dass jeder an jedem Punkt des Bildfeldes gebildete elementare Fokussierungsfleck mindestens zwei elementare Filter überdeckt, wobei die mindestens zwei elementaren Filter für die Bandpassübertragung in den Spektralbändern optimiert sind, die auf zwei verschiedenen Mittenwellenlängen zentriert sind, die gleich den zwei Erfassungswellenlängen sind,

wobei die mindestens zwei elementaren Filter jeweils einen elementaren Filter mit geführter Modenresonanz vom DMG-Typ, umfassend eine Schicht aus dielektrischem Material (31, 41, 51), die einen Singlemode-Wellenleiter mit einer zugehörigen Erfassungswellenlänge bildet, und zwei Metallgitter, die auf beiden Seiten angeordnet sind, oder einen elementaren Filter mit geführter Modenresonanz mit einer einzigen Metallisierung auf der Vorderseite, umfassend einen Wellenleiter aus dielektrischem Material mit einem Substrat auf der einen Seite und einem doppelten Metallgitter auf der anderen Seite, umfassen, wobei mindestens einer der elementaren Filter eine in ebenen Wellen gemessene Winkelakzeptanz aufweist, die größer oder gleich dem Feldrandwinkel der Vorrichtung ist, wobei der Feldrandwinkel als der Winkel des am stärksten geneigten Strahls, der die Sensorelementmatrix erreichen soll, in Bezug auf die Normalenrichtung zu dieser Sensorelementmatrix definiert ist, und bei dem eine maximale Übertragung gleich der Hälfte einer maximalen Übertragung einer identischen ebenen Welle ist, die unter einem Einfallswinkel von null auf mindestens eines der elementaren Filter auftrifft.

## Claims

1. A device (20) for infrared multispectral imaging suitable for detecting at least one first and one second detection wavelength, comprising:

- a detection matrix array (23) comprising a set of elementary detectors (23i) of preset dimensions forming an image field of given dimensions;
- an image-forming optic (22) having a given aperture number (N) and a given focal length (F) , said number and length being suitable for forming, at every point of the image field, an elementary focal spot, said focal spot covering a set of at least two juxtaposed elementary detectors;
- a matrix array (24) of elementary metallodielectric guided-mode-resonance filters (24i), said matrix array being arranged in front of the detection matrix array (23) at a distance smaller than a focal depth of the image-forming optic,

the dimensions of the elementary filters being chosen so that each elementary focal spot formed at each point of the image field covers at least two elementary filters, said elementary filters being optimized for passband transmission in spectral bands centered on two different central wavelengths, equal to two of said detection wavelengths said at least two elementary filters each comprising an dual-metallic-grating (DMG) guided-mode-resonance elementary filter comprising a layer made of dielectric material (31, 41, 51) forming a waveguide that is single mode at said associated detection wavelength, and two metallic gratings arranged on either side or one elementary guided-mode-resonance filter with a single metallization on its front face, comprising a waveguide made of dielectric material with, on one side, a substrate and, on the other side, a double metallic grating, wherein at least one of said elementary filters has an angular acceptance measured in plane waves higher than or equal to a field-edge angle of the device, where the field-edge angle is defined as the angle of the most inclined ray intended to reach the matrix array of elementary detectors with respect to a direction normal to said matrix array of elementary detectors, and for which the maximum transmittance is equal to half the maximum transmittance of an identical plane wave incident on at least one of the elementary filters with an angle of incidence of zero.

2. The device for infrared multispectral imaging as claimed in the preceding claim, wherein each of said elementary filters has dimensions substantially identical to those of one elementary detector.

3. The device for infrared multispectral imaging as claimed in any one of the preceding claims, wherein said elementary filters (24i) of the matrix array (24) of elementary filters are arranged in the form of zones (Zi), each zone comprising at least two elementary filters optimized for passband transmission in spectral bands centered on two different central wavelengths, and having dimensions larger than those of the focal spot.

4. The device for infrared multispectral imaging as claimed in any one of the preceding claims, wherein each of said at least two elementary filters comprises the elementary DMG guided-mode-resonance filter and the elementary DMG guided-mode-resonance filter is suspended and the two metallic gratings are identical.

5. The device for infrared multispectral imaging as claimed in any one of the preceding claims, wherein each of said at least two elementary filters comprises the elementary DMG guided-mode-resonance filter and the elementary DMG guided-mode-resonance filter is deposited on a substrate made of dielectric material and the two metallic gratings of the elementary filter are different.

6. The device for infrared multispectral imaging as claimed in any one of the preceding claims, wherein each of said at least two elementary filters comprises the elementary DMG guided-mode-resonance filter, and the elementary DMG guided-mode-resonance filter comprises at least one elementary guided-mode-resonance filter of the bi-atomic type, in which said at least one metallic grating has a pattern with at least two apertures of different dimensions.

7. A method for infrared multispectral imaging suitable for detecting at least one first and one second detection wavelength, comprising:

- forming an image of a scene by means of an image-forming optic of given aperture (N) and acquiring said image by means of a detection matrix array comprising a set of elementary detectors of preset dimensions forming an image field of given dimensions, the image-forming optic (22) forming at every point of the image field an elementary focal spot covering a set of at least two juxtaposed elementary detectors;
- filtering light beams focused by said image-forming optic by means of a matrix array (24) of elementary metallo-dielectric guided-mode-resonance filters, said matrix array being arranged in front of the detection matrix array (23) at a distance smaller than a focal depth of the image-forming optic so that each elementary focal spot formed at each point of the image field covers at least two elementary filters, said elementary filters being optimized for passband transmission in spectral bands centered on two different central wavelengths, equal to two of said detection wavelengths

said at least two elementary filters each comprising an dual-metallic-grating (DMG) guided-mode-resonance elementary filter comprising a layer made of dielectric material (31, 41, 51) forming a waveguide that is single mode at said associated detection wavelength, and two metallic gratings arranged on either side or one elementary guided-mode-resonance filter with a single metallization on its front face, comprising a waveguide made of dielectric material with, on one side, a substrate and, on the other side, a double metallic grating,
wherein at least one of said elementary filters has an angular acceptance measured in plane waves higher than or equal to a field-edge angle of the device, where the field-edge angle is defined as the angle of the most inclined ray intended to reach the matrix array of elementary detectors with respect to a direction normal to said matrix array of elementary detectors, and for which the maximum transmittance is equal to half the maximum transmittance of an identical plane wave incident on at least one of the elementary filters with an angle of incidence of zero.

ART ANTERIEUR

FIG.1

**FIG.2A**

FIG.2B

FIG.3A

FIG.3B

FIG.3C

FIG.4A

FIG.4B

FIG.4C

## FIG.5A

## FIG.5B

## FIG.5C

FIG.6A

FIG.6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 3971065 A

**Littérature non-brevet citée dans la description**

- **M. LEQUIME et al.** 2 × 2-Array Pixelated Optical Interference Filters. *Proc. SPIE*, 2015, vol. 9627, 96270V-1, 96270V-7
- **VOIR M. OUSSALAH et al.** ''Multispectral thin film coating on infrared detector''. *Proc. SPIE*, 2015, vol. 9627, 96271W-96271W, 10
- **AINSI, HAÏDAR et al.** Free-standing subwavelength metallic gratings for snapshot multispectral imaging''. *Appl. Phys. Lett.*, 2010, vol. 96, 221104
- **DANS SAKAT et al.** Guided mode resonance in subwavelength metallodielectric free-standing grating for bandpass filtering. *Opt. Lett.*, 2011, vol. 36, 3054
- **SAKAT et al.** Metal-dielectric bi-atomic structure for angular-tolerant spectral filtering. *Opt. Lett.*, 2013, vol. 38 (425)
- **M.G. MOHARAM et al.** Rigorous coupledwave analysis. *JOSAA*, 1995, vol. 12, 1068
- **P. HUGONIN ; P. LALANNE**. Reticolo software for grating analysis. *Institut d'Optique*, 2005
- **C. TARDIEU et al.** *Optics Letters*, 2015, vol. 40 (4)
- **MEHRDAD SHOKOOH-SAREMIAND et al.** ''Particle swarm optimization and its application to the design of diffraction grating filters,. *Opt. Lett.*, 2007, vol. 32, 894-896
- **C. TUAMBILANGANA et al.** *Optics Express*, 2015, vol. 23, 25